# EUROPEAN PATENT APPLICATION

(11) **EP 2 796 834 A1**
(43) Date of publication of application: **29.10.2014**
(21) Application number: 13305535.0
(22) Date of filing: 23.04.2013
(51) Int. Cl.: G01D 4/00

(54) **Radio frequency identification system**

(71) Applicant: Thomson Licensing, 92130 Issy-les-Moulineaux (FR)
(72) Inventor: Louzir, Ali, 35576 Cesson Sévigné (FR); Le Naour, Jean-Yves, 35 576 Cesson Sévigné (FR); Robert, Jean-Luc, 35 576 Cesson Sévigné (FR)
(74) Representative: Huchet, Anne

(57) **Abstract**

The present invention relates to RFID system for detection of the activity of home electrical appliances of a home equipment comprising
An electricity meter (30) for measuring the power consumption of the home electrical appliances (22),
RFID sensing tags taped to the power supply cord of each home electrical appliance, the system further comprising
means for detecting a change of the home electrical appliances power consumption delivered by the electricity meter;
a radio frequency identification (RFID) tag reader, triggered by the detecting means if a change is detected, reading data from the RFID sensing tags, the data comprising identification code and the state (on or off) of each appliance

Means for identifying a change of state of at least one appliance in analyzing the data read by the triggered RFID tag reader,
and means for delivering information concerning the change of state of the at least one identified appliance.

## Description

### FIELD OF THE INVENTION

The invention concerns a radio frequency identification (RFID) system for detection of the activity of electrical appliances of home equipment.

The invention could be used in home management for energy monitoring or in content recommendation applications

### BACKGROUND OF THE INVENTION

The deployment of sensors based systems offers many opportunities of new services and applications. In particular in the area of home networking, a Home Gateway platform or a Tablet may include an interface allowing the user to have a feedback on the energy consumption of various home appliances.

The Home Gateway or the Tablet may also include or interface with an advanced search and recommendation system, and it could be worth for such a system to augment the existing data base about the user preferences and habits with real time context information, including for example his location or current activity. Thus, the knowledge of the activity of home appliances such as a coffee machine, a toaster, a microwave oven, a vacuum, a wash machine, a lamp, etc.., may provide interesting information on the user real time activity and can be used in different applications such as energy monitoring or energy management

For these classes of applications known solutions uses advanced meter systems based on remote controlled modules plugged to wall outlets. The advanced meter systems measure the electrical consumption of the equipment powered from that wall outlet. In addition, the wall plugged modules are equipped with a wireless communication system generally based on wireless low power technology to remotely monitor and control the home appliance. The user manual of Zig Bee Power Plug (ZPLUG) revision 3.0 described such a module. It is able to monitor the electricity consuming of an appliance plugged into it. The ZPLUG contains an application which switches on/off the appliance plugged into the plug, measures the consumption of the plugged appliance and is able to send the current demand of energy in KWh and the most recent summed value of energy used in KWh.

Patent document CN191776754 discloses an automatic identification method which involves installing electronic tags and identifiers on a power equipment to be identified and located. Several antennae are installed in different areas of the installation for detecting the electronic tags. The electronic tag data is acquired by a reading device via antennae. The position information of the identified electronic tags is analyzed by the reading device. The position information of the power asset is thus determined by this method but the activity of the different home electrical appliances is not analyzed.

Patent document KR891201 discloses an apparatus for measuring electric power usage. A RFID tag is connected to an individual switch. It gives the corresponding ID. A sensor senses operation time information according to the on/off state of the individual switch connected to an electrical lamp for the power consumption computation. The RFID tag gives an identification information but does not sense the on/off state of the coresponding apparatus.

Patent document CN102496814 discloses a RFID tag reader and a wireless sending and receiving module transmitting the ID to an intelligent gateway..The RFID tag gives an identification information but does not sense the on/off state of the coresponding apparatus.

Thus, an object of the invention is to propose a simple solution for real time wireless capture of the activity of home electrical appliances.

### SUMMARY OF THE INVENTION

The invention consists in a RFID system for detecting the activity of home electrical appliances of home equipment comprising an electricity meter for measuring the power consumption of the home electrical appliances and RFID sensing tags taped to the power supply cord of each home electrical appliance.

The system comprises further means for detecting a change of the home electrical appliances power consumption delivered by the electricity meter, a radio frequency identification (RFID) tag reader, triggered by the detecting means if a change is detected, reading data from the RFID sensing tags, the data comprising identification code and the state (on or off) of each appliance, means for identifying a change of state of at least one appliance in analyzing the data read by the triggered RFID tag reader and means for delivering information concerning the change of state of the at least one identified appliance.

Thus, the state change (switch on or switch off) of an electrical home appliance could be detected and information stored in the RFID tag memory.

Preferably, the change of the home electrical appliance power consumption delivered by the home electricity meter is due to state change of an electrical home appliance.

According to an aspect of the invention, each RFID sensing tag comprises an antenna operating in the UHF band.

Preferably, the RFID system is embedded in a Home Gateway

Preferably, each passive RFID sensing tag includes a passive sensor which allows the detection of the impulse current flowing through the power supply cord when the state of the electrical home appliance is changing.

### BRIEF DESCRIPTION OF THE DRAWINGS

The above and other aspects of the invention will become more apparent by the following detailed description of exemplary embodiments thereof with reference to the attached drawings in which:
Figure 1 is a block diagram of the concept of the invention;
Figure 2 is a block diagram of the UHF RFID tag with pulse detection;
Figures 3a and 3b illustrate the principle of the pulse detection;
Figure 4 represents schematic examples of RFID UHF antennas, including loops, suitable for pulse detection;
Figure 5 represents an example of recorded impulse at switch on/off, obtained with an UHF passive tag wound around the hairdryer power cord;
Figure 6 represents an example of recorded impulse at switch on/off, obtained with an UHF passive tag wound around the juice extractor power cord.

### DETAILED DESCRIPTION OF PREFERRED EMBODIMENTS

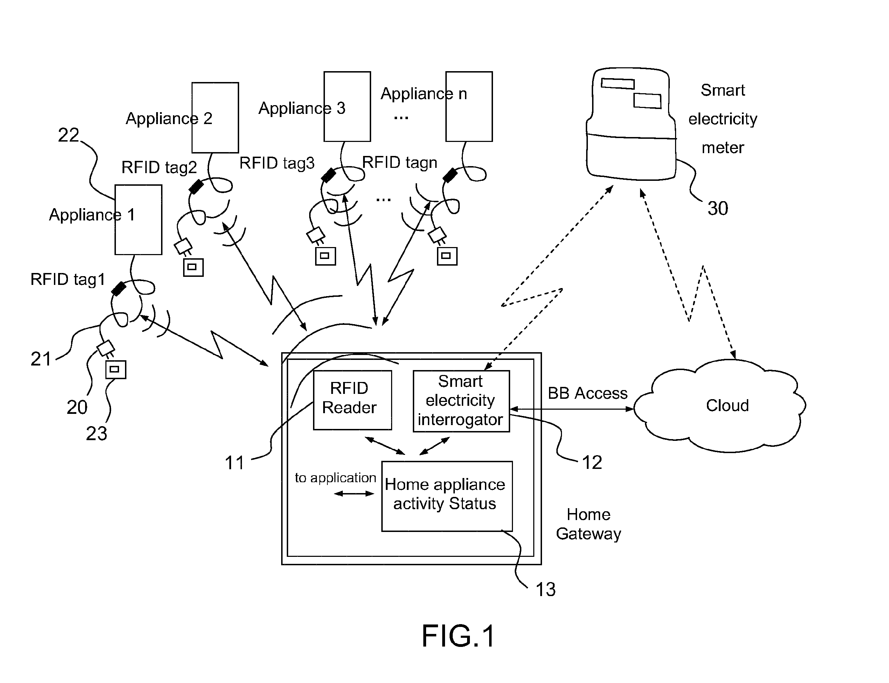

As shown in figure 1,the invention consists in a relatively long range RFID system 10 operating for example in the UHF band, constituted by a RFID reader 11, situated for example in the Home Gateway, associated to RFID sensing tags 20 taped to the power supply cords 21 of electrical home appliances 22 . Each UHF RFID sensing tag 20 includes a unique identification code ID of the corresponding electrical home appliance and a passive switch ON/OFF sensor, integrated to the RFID tag, allows the detection of the impulse current (current spikes) flowing through the supply cord 21 when the appliance is switched on/off. Thus, the state change (switch on or switch off) of the electrical home appliance could be detected and information stored in the RFID tag memory.

The RFID system is coupled to a home smart electricity meter 30 which measures in real time the home total power consumption. Any variation in the consumed power triggers an interrogation phase of the RFID reader 11.

Therefore, by crossing the backscattered information from the interrogated tags with the total power variation provided by the smart meter, using an application running for example in the Home Gateway, it is possible to identify with good reliability which appliance is activated and if it is switched on or switched off.

For example, if an electrical device connected to the home power line, let's say a coffee machine, is switched on:
1. The home total power consumption will increase by an amount corresponding to the power consumed by the coffee machine.
2. The impulse current flowing in the power cord at the switch on activates the RFID tag taped on the power cord, and the status information change (OFF-> ON) is stored in the tag chip memory by switching one bit (the "status bit") from 0 (corresponding to OFF state) to 1 (corresponding to ON state)

The change of the total power is transmitted by the smart meter to the smart electricity interrogator module in the Gateway and triggers a read phase of the RFID reader. The RFID reader reads all the RFID tags of the tagged electrical devices. The read information of each tag includes its identification and its status ON/OFF. By comparing the status of all the read devices with the previous one stored in electrical devices status file, at the previous reading phase, it is possible to infer which electrical device has been powered on and the file of electrical devices status is updated.

Real time tracking of the total home power consumption could be provided by the home electricity provider through a broadband access using the cloud. Therefore, this information could be used by the Gateway connected to the cloud to trigger the RFID reading phase.

Figure 1 shows a block functional diagram illustrating the invention.

N different electrical home appliances such as appliance 1, appliance 2, and appliance 3, appliance n, referenced 22 are connected by power supply cords 21 to N different plugs 23, so that the plugged electrical home appliances are electrically connected to a home electrical network. Each appliance is identified by an ID code.

For each appliance, a RFID sensing tag 20 comprises an antenna taped to the power supply cord 21. To a RFID sensing tag operating for example in the UHF band, a unique identification code ID corresponds to the electrical home appliance to which it is connected. In addition to its basic identification functionality, a passive impulse current sensor allows the detection of a change of state of the corresponding appliance. Any state change from a switch on state to a switch off state or from a switch off state to a switch on state is detected by the passive sensor which is by example a pulse detector, integrated in the IC of the RFID tag taped to the supply cord of the appliances to be sensed. The state change could be easily detected by a conductor loop, integrated in the UHF tag antenna and connected to an IC chip. The voltage induced when switching on/off the appliance is sufficient to activate the IC chip and to store this information of the state change in the RFID tag memory of the RFID tag antenna by changing the value of one bit memory, so called "status bit", (from 0 to 1 and vice versa) of the RFID chipset. This information will be transmitted together with the appliance identification code by the tag antenna.

The application aims to detect the activity of the "tagged" home electrical appliances and uses real time information on the total home power consumption given by the electricity meter 30.. The smart electricity meter 30 measures in real time the total home power consumption. The smart electricity meter is for example a power sensor or a current sensor,

The RFID system of the invention operating in the UHF band is further represented in the figure 1. It is constituted by the RFID sensing tags 20 taped to the power supply of each electrical home appliance, RFID reader 11, the electricity interrogator 12 and a home appliance activity status device 13 which could be hosted, for example in the Home Gateway.

The switch off or switch on of an electrical home appliance induces a change in the total home power consumption measured by the smart electricity meter 30. This change is transmitted to the smart electricity interrogator 12 which triggers the RFID reader. The triggering of the RFID reader corresponds to an interrogation phase of the RFID reader. Therefore, by reading information of the RFID tag antenna from the tagged electrical home appliances in the home appliance activity status device 13 which includes the tag unique ID and the "state bit" value associated to the electrical home appliance, it is possible to infer which "state bit" value has changed and consequently which electrical home appliance identified by the ID code have been activated or deactivated. This information is thus transmitted to a further application corresponding for example to an edit mode or to an alarm system if necessary.

A RFID system of the invention transmits electrical information, such as switching off or on, of the different electrical home appliances identified with ID code.

The switch on or off ambiguity could be removed by the knowledge of the state (on or off) at the previous reading. It can be provided by an initialization phase which is done, for example at the registration of a new tagged electrical home appliance.

The reliability of the information on which appliance have been switched on or off, could be further improved by comparing the data provided by the smart electricity meter 30 . If the data representing the power consumption increases, it should correspond to an appliance which has been switched on or if the data representing the power consumption decreases, it should correspond to an appliance which has been switched off. The knowledge, a priori, of the power consumption of each tagged appliance should permit to improve the reliability of the information.

The power consumption of the appliance may be stored in the tag, too and thus may be part of the information read by the RFID reader at the interrogation phase, or it could be already stored in the Gateway and used by the application.

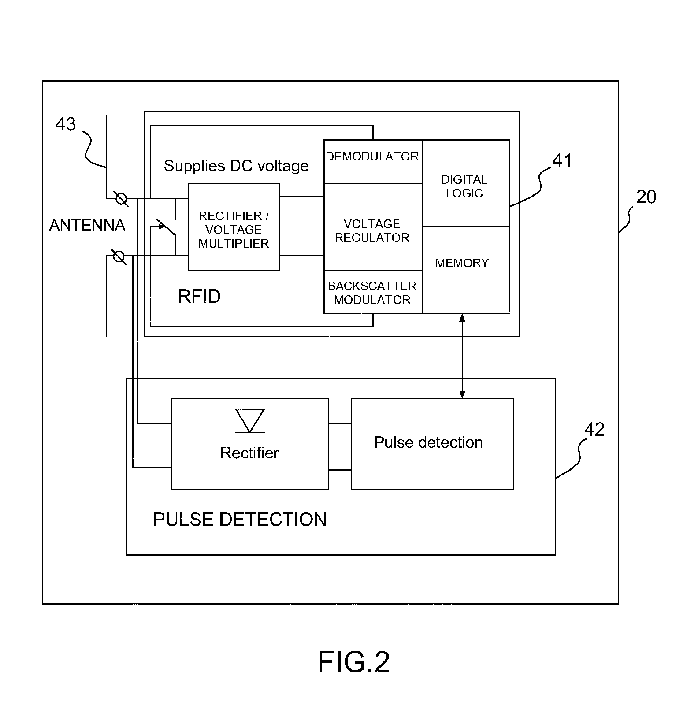

Figure 2 presents the block diagram of a proposed RFID sensing tag of the invention. It is based on a classical UHF RFID sensing tag with an additional dedicated circuit which corresponds to a loop integrated in the UHF antenna and a pulse detection circuit aiming to detect the pulse induced in the loop surrounding the supply cord (pulse detection) and to deliver an information to the RFID memory by changing the value of one bit memory, so called "state bit", (from 0 to 1 and vice versa) of the RFID chipset.

The RFID sensing tag 20 used by the invention is a classical RFID Ultra High Frequency (UHF) passive tag 41 comprising a properly designed antenna 43 in order to match the form factor of the power cord. Sensing tags are almost standard passive UHF standard compliant RFID tags to which an impulse sensor circuit 42 is connected.

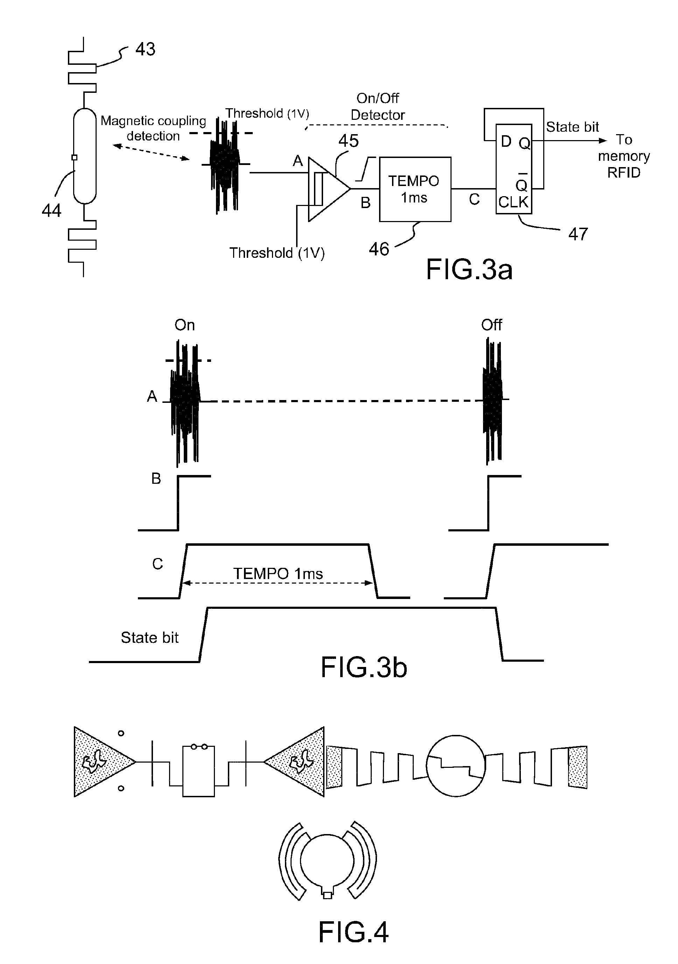

Figure 3a illustrates the pulse detection principle of the impulse sensor circuit 42 inserted within the sensing block of the UHF RFID sensing tag 20. The On /off pulse signal A is picked up by the loop part 44 of the UHF tag antenna 43, via a magnetic coupling effect. When the amplitude of the on/off pulse signal A represented by the figure 3b exceeds a dedicated threshold ( # 1 V for example), the block comparator 45 detects a pulse in changing the state of the output signal B. In order to avoid multi triggering, a temporization device 46 is inserted behind the comparator so that the issued signal C at the output corresponds to the signal issued from the comparator during a temporization time. A "D flip flop"47 realizes the generation of the "state bit", changing the state for each clocked impulse as the D Flip Flop is clocked by the temporization device issued signal . Thus this last bit changes its state for each detected pulse (at switch on or off) and its value is stored in the memory part of the RFID sensing tag 41. This information is then transmitted with the appliance identification code ID at every interrogation done by the RFID reader 11. Signals A,B,C and State bit are further represented on the diagram of the figure 3b.

Figure 4 shows examples of RFID sensing tag comprising UHF antennas with integrated loop for impulse current detection and its connection the RFID read/write Integrated Circuit. The shape of this well known antenna responds to an optimized design to match the form factor of the power cord.

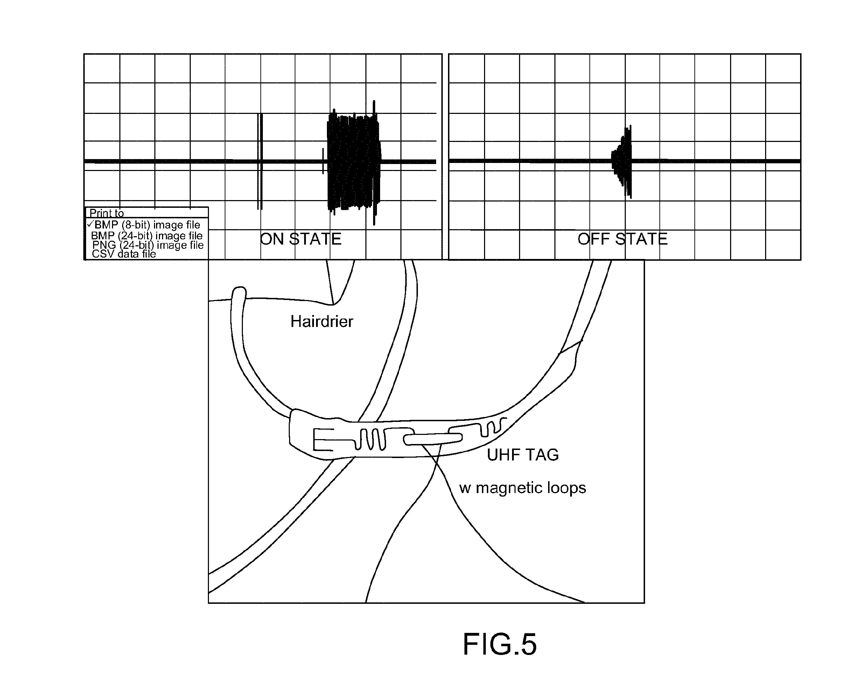

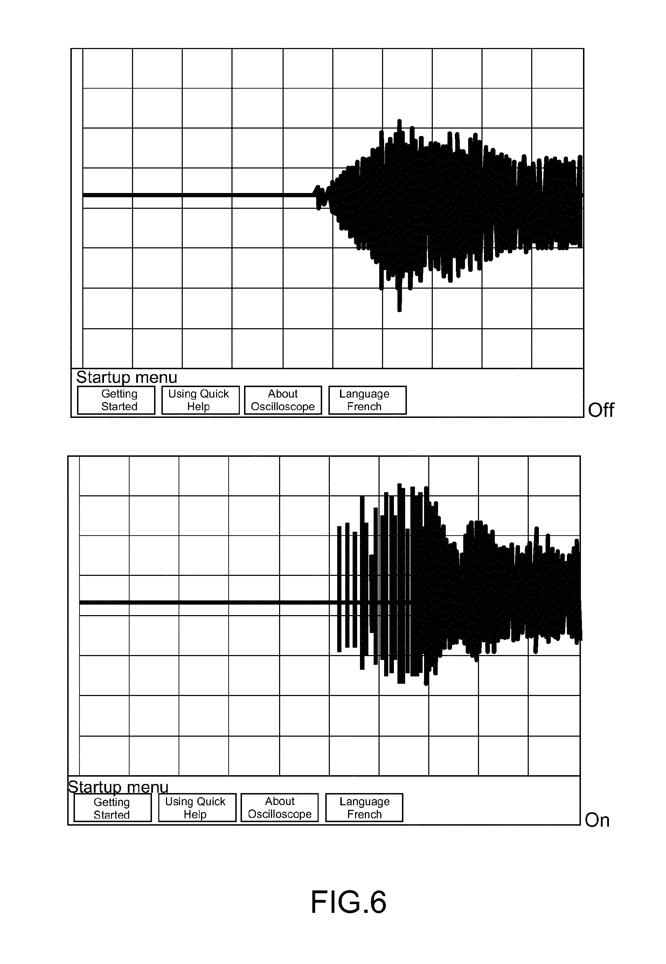

Extensive tests done on various home appliances are presented in Figure 5 and Figure 6. It shows the measured impulse voltage induced in a wire loop surrounding the supply cord, at the switch-on and switch-off of various home appliances. The induced voltage, measured by an oscilloscope (for example a DS06104A from Agilent Technologies) often exceeds few volts and is always superior to 1 V for all the tested equipments.

Figure 5 presents the recorded impulse response for a hairdryer obtained at the antenna input of a flexible RFID tag wound around the hairdryer power cord as shown on the photo. The impulse voltage exceeds 1 V peak to peak at both switch off and switch on of the hairdryer. This detected switch on impulse voltage changes the value of the state bit. And further, the detected switch off impulse voltage changes again the value of the state bit.

Figure 6 presents the recorded impulse response for a juice extractor obtained at the antenna input of a flexible RFID tag wound around the juice extractor power cord. This detected switch on/off impulse voltage changes the value of the state bit.

Thus the power on/off of the electrical appliance could be detected by a properly designed RFID tag using the impulse voltage induced by the current flowing in the supply cord at switch off/on and does not require to be powered by the RFID reader. Therefore, the information on the state change is obtained independently from the reader and is stored in the chip memory by changing the value of one bit memory, so called "state bit", (from 0 to 1 and vice versa) of the RFID chipset.

Finally, the real time knowledge of the activity of all "tagged" electrical appliances activity could be used for home energy monitoring or as complementary user context information in content recommendation applications.

The information on the real time home power consumption could be obtained by a smart meter system using "Zigbee" technology or similar radio technology installed in the Gateway or through an operator web site

If required, for example for large homes/or other long range applications, several RFID readers could be used for tag sensor interrogation. All the RFID readers may be interconnected and linked to a central node situated in the GW using a "ZigBee" radio for example.

## Claims

1. RFID system for detection of the activity of home electrical appliances of an home equipment comprising
an electricity meter (30) for measuring the power consumption of the home electrical appliances (22),
RFID sensing tags taped to the power supply cord of each home electrical appliance,
**Characterized in that** the system comprises further
means for detecting a change of the home electrical appliances power consumption delivered by the electricity meter;
a radio frequency identification (RFID) tag reader, triggered by the detecting means if a change is detected, reading data from the RFID sensing tags, the data comprising identification code and the state (on or off) of each appliance
means for identifying a change of state of at least one appliance in analyzing the data read by the triggered RFID tag reader,
and means for delivering information concerning the change of state of the at least one identified appliance.

2. System according to claim 1 **characterized in that** the change of the home electrical appliances power consumption delivered by the home electricity meter is due to state change of at least one electrical home appliance.

3. System according to claim 1 **characterized in that** each RFID sensing tag comprises an antenna operating in the UHF band.

4. System according to claim 1 **characterized in that** the RFID system is embedded in a Home Gateway.

5. System according to claim 1 **characterized in that** each passive RFID sensing tag includes a passive sensor which allows the detection of the impulse current flowing through the power supply cord when the state of the electrical home appliance is changing.
